Europäisches Patentamt

European Patent Office

Office européen des brevets

(11) Publication number: **0 124 316**
**A1**

(12) ## EUROPEAN PATENT APPLICATION

(21) Application number: **84302601.4**

(22) Date of filing: **17.04.84**

(51) Int. Cl.³: **H 03 D 3/16**

(30) Priority: **22.04.83 GB 8311073**

(43) Date of publication of application: **07.11.84**
**Bulletin 84/45**

(84) Designated Contracting States: **BE DE FR GB IT NL SE**

(71) Applicant: **SINCLAIR RESEARCH LIMITED, 25 Willis Road, Cambridge CB1 2AQ (GB)**

(72) Inventor: **Beesley, Graham E., Upcott Cottage Church Lane, Sparsholt Winchester Hants S021 2NJ (GB)**

(74) Representative: **Colgan, Stephen James et al, CARPMAELS & RANSFORD 43 Bloomsbury Square, London WC1A 2RA. (GB)**

(54) **Frequency discriminators.**

(57) A frequency discriminator for use in obtaining the A.F. signal from a frequency-modulated R.F. signal in F.M. radio receiver comprising a two pole bandpass filter 6, a differential peak detecting transistor 14, and a low frequency amplifier 16. The transistor 14 is stabilised by a feedback line 18.

EP 0 124 316 A1

## "FREQUENCY DISCRIMINATORS"

This invention relates to frequency disciminators, particularly for use in obtaining the A.F. signal from an incoming frequency-modulated R.F. signal in an F.M. radio receiver.

With the desire in the electronics industry for the miniaturisation of components and circuits, a frequency discriminator which uses a minimal number of components and capable of operation at low voltage is clearly of interest. We have now devised such a circuit, which is suitable for use in a miniature F.M. radio receiver.

According to the invention, we provide a frequency discriminator comprising a frequency filter, means for enabling a frequency-modulated input signal to be provided to said filter, means for obtaining from the filter a signal whose phase relative to said input signal varies as a function of frequency, a differential peak detecting transistor for receiving said input signal and the phase-variant signal, for detecting said phase variation and for providing an output signal characteristic of the modulation of said input signal, and means for stabilising the peak detecting transistor by feedback from the output signal.

Various types of filters may be employed in the circuit to provide the phase-variable signal - either high, low or bandpass-type filters. The filter should however preferably provide a constant amplitude signal across its range of operating frequencies. The filter may be an RC or LC circuit, or a quartz resonator. We prefer to employ ceramic filters since, inter alia, these are very compact.

The input F.M. signal and the phase-variant signal from the filter are supplied directly to a differential peak detector whose bias is stablised by direct current feedback. The advantage of feedback is to provide low output impedance and increased gain.

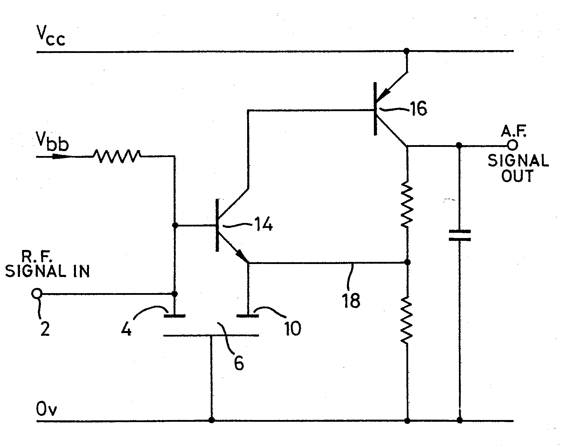

Preferred features of the invention will now be described with reference to the accompanying drawing, which illustrates a circuit diagram of an embodiment for use in an F.M. radio receiver.

The frequency-modulated R.F. signal is applied to the circuit at 2, and to one pole 4 of a ceramic two pole bandpass filter 6. The input signal 2 also is supplied to the base of a transistor 14, biassed with a voltage $V_{bb}$. The emitter of the transistor 14 is connected to the second pole 10 of the filter and which provides the phase-variant signal. The collector of the transistor 14 is connected to a second transistor 16 which acts as a low frequency amplifier. The A.F. output signal is obtained from the collector of transistor 16 whereas a feedback to the emitter of transistor 14 is provided by line 18 to stabilise the bias on the latter transistor.

In use, $V_{bb}$ biasses the base of transistor 14 at about 0.7 volts onto which is applied the incoming R.F. signal. The signal seen at the pole 10 or filter 6 varies in phase from 0 to 180° relative to the R.F. signal at pole 4 depending on the frequency of the latter signal.

The filter is selected such that at one extreme of the input frequency range the phase shift is small and correspondingly a small output signal results whilst at the other extreme of the input frequency range the phase shift is close to 180° and hence maximum output is obtained. the condition if no modulation exists results in an approximately 90° phase shift. A central output value results. Modulation causes the output to swing about this central value.

In a further embodiment, which is a variation of that shown in the drawing, the two pole ceramic filter 6 is replaced by a single pole ceramic filter
connected between the base and emitter of transistor
14.

CLAIMS:-

1. A frequency discriminator comprising a frequency filter, means for enabling a frequency-modulated input signal to be provided to said filter, means for obtaining from the filter a signal whose phase relative to said input signal varies as a function of frequency, a differential peak detecting transistor for receiving said input signal and the phase-variant signal, for detecting said phase variation and for providing an output signal characteristic of the modulation of said input signal, and means for stabilising the peak detecting transistor by feedback from the output signal.

2. A discriminator according to claim 1 wherein the peak detecting transistor is coupled to an amplifier a proportion of whose output is provided back to said transistor as said feedback.

3. A discriminator according to claim 1 or 2 wherein the peak detecting transistor is bipolar, the input signal being supplied to the base of the transistor and the phase-variant signal to the emitter of the transistor.

4. A discriminator according to any of claims 1 to 3 wherein said filter is a bandpass filter.

5. A disciminator according to claim 4 wherein said filter is a two pole ceramic filter.

6. A discriminator according to any of claims 1 to 3 wherein said filter is a single pole ceramic filter.

0124316

1/1

European Patent Office

**EUROPEAN SEARCH REPORT**

Application number

EP 84 30 2601

## DOCUMENTS CONSIDERED TO BE RELEVANT

| Category | Citation of document with indication, where appropriate, of relevant passages | Relevant to claim |
|---|---|---|
| A | US-A-3 648 184 (FUJISHIMA et al.)<br>* Column 1, line 4 - column 4, line 66; figures 3,4,5 * | 1 |
| | --- | |
| A | GB-A-1 170 028 (PYE LTD.)<br>* Page 1, line 65 - page 3, line 68; figure * | 1 |
| | --- | |
| A | US-A-3 843 932 (FISCHMAN)<br>* Column 2, line 9 - column 4, line 32; figure 1 * | 1 |
| | ----- | |

**CLASSIFICATION OF THE APPLICATION (Int. Cl. ³)**

H 03 D 3/16

**TECHNICAL FIELDS SEARCHED (Int. Cl. ³)**

H 03 D

The present search report has been drawn up for all claims

| Place of search | Date of completion of the search | Examiner |
|---|---|---|
| THE HAGUE | 30-07-1984 | DHONDT I.E.E. |